# EUROPEAN PATENT SPECIFICATION

(11) **EP 4 207 318 B1**
(45) Date of publication and mention of the grant of the patent: **16.04.2025**
(21) Application number: 20951218.5
(22) Date of filing: 04.12.2020
(51) Int. Cl.: H01L 31/107, H01L 31/0232, H01L 31/028, H01L 31/0352, H01L 31/18, G02B 6/12

(54) **AVALANCHE PHOTODETECTOR AND PREPARATION METHOD THEREFOR**
LAWINENFOTODETEKTOR UND HERSTELLUNGSVERFAHREN DAFÜR
PHOTODÉTECTEUR À AVALANCHE ET PROCÉDÉ DE PRÉPARATION S'Y RAPPORTANT

(30) Priority: 31.08.2020 CN 202010901268
(43) Date of publication of application: 05.07.2023
(73) Proprietor: Wuhan Optical Valley Information Optoelectronics Innovation Center Co., Ltd, Wuhan, Hubei 430074 (CN)
(72) Inventor: HU, Xiao, Wuhan, Hubei 430074 (CN); XIAO, Xi, Wuhan, Hubei 430074 (CN); CHEN, Daigao, Wuhan, Hubei 430074 (CN); WANG, Lei, Wuhan, Hubei 430074 (CN); ZHANG, Yuguang, Wuhan, Hubei 430074 (CN); LI, Miaofeng, Wuhan, Hubei 430074 (CN)
(74) Representative: Gevers Patents
(86) International application number: PCT/CN2020/134059
(87) International publication number: WO 2022/041550

(56) References cited:
- CN-A- 105 957 908
- CN-A- 108 022 985
- CN-A- 108 110 081
- CN-A- 109 155 340
- CN-A- 111 029 422
- CN-A- 112 018 211
- US-A1- 2007 152 289
- US-A1- 2015 097 256
- US-B1- 9 748 429

## Description

### CROSS-REFERENCE TO RELATED APPLICATION

The application is based on and claims priority to Chinese Patent Application No. 202010901268.8 filed on August 31, 2020.

### TECHNICAL FIELD

The disclosure relates to the technical field of photon integrated chip detection, in particular to an avalanche photodetector and a preparation method therefor.

### BACKGROUND

A photodetector is one of the key photoelectric devices in optical communication, optical interconnection, and photoelectric integration technologies. At present, the photodetector is widely used in various fields of military and national economies, in which an avalanche photodetector is welcomed by the market because of its high responsiveness and sensitivity.

US2007/152289 A1 discloses an avalanche photodetector, which includes an absorption region including a first type of semiconductor material, a multiplication region including a second type of semiconductor material proximate to and separate from the absorption region and a reflector disposed proximate to the multiplication region. CN 111029422 A discloses a photoelectric detector based on higher-order modes, which includes a detector body and a mode converter. The detector body includes a germanium absorption region which is surrounded and covered by an epitaxial silicon region. US 2015/097256 A1 discloses a semiconductor device, which includes a waveguide that overlies a buried oxide layer of a semiconductor substrate. An avalanche photodetector diode is disposed about a recessed waveguide layer section. A silicon cap is selectively deposited onto a germanium absorption region of the photodetector diode.

However, the current avalanche photodetector has disadvantages of high dark current and low responsiveness, so further improvements are needed.

### SUMMARY

In view of this, the invention provides an avalanche photodetector and a preparation method therefor, so as to solve at least one problem existing in the art.

In order to achieve the above purpose, technical solutions of the invention are realized as follows:

In one aspect, an avalanche photodetector is provided. The avalanche photodetector includes a substrate and a device structure layer located on the substrate. The device structure layer at least includes a charge layer, a transition layer, an absorption layer and a first electrode contact layer which are sequentially arranged upward in a direction perpendicular to a plane of the substrate.

The charge layer is a layer of first a semiconductor material having a first doping type.

The transition layer is epitaxially grown on the charge layer, and the transition layer is an intrinsic layer.

The absorption layer is epitaxially grown on a first region of the transition layer, and the absorption layer is an intrinsic layer of a second semiconductor material.

The first electrode contact layer is epitaxially grown on a second region of the transition layer, and has a height higher than a height of the absorption layer so that the first electrode contact layer covers the absorption layer. The first electrode contact layer is a layer of the first semiconductor material.

A material of the transition layer is a composite material of the first semiconductor material and the second semiconductor material.

In an optional embodiment of the disclosure, the first semiconductor material is silicon, the second semiconductor material is germanium, and the composite material of the first semiconductor material and the second semiconductor material is silicon-germanium.

In an optional embodiment of the disclosure, the first doping type is P type.

In an optional embodiment of the disclosure, the avalanche photodetector further includes a first electrode contact region located in the first electrode contact layer, in which the first electrode contact region is a region of the first semiconductor material having the first doping type.

In an optional embodiment of the disclosure, the second region surrounds the first region. Alternatively, the second region includes two sub-regions separated by the first region.

In another aspect, a method for preparing an avalanche photodetector is provided. The method includes the following operations.

A substrate is provided.

A first epitaxial layer is grown on the substrate, in which the first epitaxial layer is a layer of a first semiconductor material. Ion doping of a first doping type is performed on the first epitaxial layer to form a charge layer.

A second epitaxial layer is grown on the charge layer to form an intrinsic transition layer. A material of the second epitaxial layer is a composite material of the first semiconductor material and a second semiconductor material.

A third epitaxial layer is grown on a first region of the transition layer to form an intrinsic absorption layer. The third epitaxial layer is a layer of the second semiconductor material.

A fourth epitaxial layer is grown on a second region of the transition layer, and has a height higher than a height of the third epitaxial layer to form a first electrode contact layer covering the absorption layer. The fourth epitaxial layer is a layer of the first semiconductor material.

In an optional embodiment of the disclosure, the first semiconductor material is silicon, the second semiconductor material is germanium, and the composite material of the first semiconductor material and the second semiconductor material is silicon-germanium.

In an optional embodiment of the disclosure, the first doping type is P type.

In an optional embodiment of the disclosure, the method further includes an operation of performing ion doping of a first doping type on the fourth epitaxial layer to form a first electrode contact region in the first electrode contact layer.

In an optional embodiment of the disclosure, the second region surrounds the first region. Alternatively, the second region includes two sub-regions separated by the first region.

According to the invention, by arranging the transition layer and using the composite material of the semiconductor material and the second semiconductor material as the material of the transition layer, a better lattice matching can be obtained between the transition layer and the charge layer, and between the absorption layer and the first electrode contact layer. Therefore, on the one hand, the transition layer can be well grown on the charge layer, while avoiding the lattice mismatch problem caused by growing the absorption layer directly on the charge layer; on the other hand, by epitaxially growing the absorption layer by means of the first region of the transition layer, and epitaxially growing the first electrode contact layer by means of the second region of the transition layer, both the absorption layer and the first electrode contact layer have better growth quality, which is not only conducive to reducing the dark current and improving the responsiveness of the detector, but also makes the device structure simple and the process cost low.

### BRIEF DESCRIPTION OF THE DRAWINGS

FIG. 1 is a side sectional view of an avalanche photodetector in the related art.
FIG. 2 is a side sectional view of an avalanche photodetector provided by an embodiment of the disclosure.
FIG. 3 is a top view of the avalanche photodetector provided by the embodiment of the disclosure.
FIG. 4 is a top view of a transition layer of an avalanche photodetector provided by another embodiment of the disclosure.
FIG. 5 is a flowchart of a method for preparing an avalanche photodetector provided by an embodiment of the disclosure.
FIG. 6A to FIG. 6H are side sectional views of structures of an avalanche photodetector provided by an embodiment of the disclosure during the process of preparing.

### Reference signs:

111-bottom substrate; 112-buried oxygen layer;
113-top silicon layer (silicon flat layer); 1131-first doped region; 1132-second doped region (second electrode contact region); 1133-second metal electrode;
120-avalanche layer;
30, 130-charge layer;
140-transition layer (interface layer); 141, 141'-first region; 142, 142'-second region;
50, 150-absorption layer;
60, 160-first electrode contact layer (fourth epitaxial layer); 61,161-first electrode contact region; 162- first metal electrode;
170-filling layer;
180-optical waveguide; 181-optical input port; 182-first waveguide region.

### DETAILED DESCRIPTION

Exemplary embodiments disclosed by the present disclosure are embodiments of the invention and will be described in more detail below with reference to the accompanying drawings. Although exemplary embodiments of the disclosure are shown in the drawings, it should be understood that the disclosure may be implemented in various forms and should not be limited to the specific embodiments set forth herein. Actually, these embodiments are provided for the purpose that the disclosure will be more thoroughly understood and the scope of the disclosure will be fully conveyed to those skilled in the art.

In the description below, numerous specific details are given for thorough understanding of the embodiments of the disclosure. However it will be apparent to those skilled in the art that the embodiments of the disclosure may be implemented without one or more of these details. In other examples, some technical features well-known in the art are not described, in order to avoid confusion with the embodiments of the disclosure. That is, not all features of actual embodiments are described herein, but well-known functions and structures are not described in detail.

In the drawings, the sizes of a layer, a region, and an element and their relative sizes may be exaggerated for clarity. The same reference sign denotes the same element throughout the text.

It should be understood that while an element or a layer is referred to as being "on", "adjacent to", "connected to" or "coupled to" other elements or layers, it may be directly on the other elements or layers, adjacent to the other elements or layers, or connected to or coupled to the other elements or layers, or an intermediate element or layer may be existent therebetween. In contrast, while an element is described as being "directly on", "directly adjacent to", "directly connected to" or "directly coupled to" other elements or layers, there is no intermediate element or layer therebetween. It should be understood that although the terms "first", "second", "third" and the like may be used to describe various elements, components, regions, layers, and/or portions, these elements, components, regions, layers, and/or portions should not be limited by these terms. These terms are only used to distinguish one element, component, region, layer or portion from another element, component, region, layer or portion. Therefore, without departing from the teaching of the embodiments of the disclosure, a first element, component, region, layer, or portion discussed hereinafter may be expressed as a second element, component, region, layer, or portion. While discussing a second element, component, region, layer, or portion, it does not mean that the first element, component, region, layer, or portion is necessarily present in the embodiments of the disclosure.

Spatial relationship terms such as "under ...", "below ...", "lower", "underneath ...", "above ...", "upper" and the like may be used herein for conveniently describing a relationship between one element or feature and another element or feature shown in the drawings. It should be understood that, the spatial relationship terms are intended to further include different orientations of a device in use and operation, in addition to the orientations shown in the drawings. For example, if the device in the drawings is turned over, the element or feature described as being "below" or "under" or "beneath" other elements will be oriented as being "above" the other elements or features. Therefore, the exemplary terms "below" and "under" may include two orientations of up and down. The device may be otherwise oriented (e.g., rotation for 90 degrees or other orientations), and the spatial terms used herein are interpreted accordingly.

The terms used herein are intended to describe specific embodiments only and are not to be a limitation to the embodiments of the disclosure. As used herein, singular forms "a/an", "one", and "said/the" are also intended to include plural forms, unless otherwise clearly indicated in the context. It should be further understood that terms "composing" and/or "including", while used in the specification, demonstrate the presence of the described features, integers, steps, operations, elements and/or components, but do not exclude the presence or addition of one or more other features, integers, steps, operations, elements, components, and/or groups. As used herein, a term "and/or" includes any and all combinations of related items listed.

In order to thoroughly understand the embodiments of the disclosure, detailed operations and structures will be set forth in the following description to illustrate the technical solution of the present disclosure. Optional embodiments of the disclosure are described in detail below. However the disclosure may be implemented via other embodiments, in addition to these detailed descriptions.

Silicon photon technology is a new generation technology, which is based on silicon and silicon-based substrate materials (such as SiGe/Si, silicon on insulator, etc.), and uses the existing complementary metal oxide semiconductor (CMOS) process to develop and integrate optical devices. Silicon photon technology combines the characteristics of ultra-large scale and ultra-high precision manufacturing of integrated circuit technology with the advantages of ultra-high speed and ultra-low power consumption of photon technology, and thus is a disruptive technology to deal with the failure of Moore's Law. This combination is due to the scalability of semiconductor wafer manufacturing, so the cost can be reduced. The photodetector, as one of the core devices of silicon photon architecture, has the function of converting optical signal to electrical signal. However, the energy band structure of crystalline silicon determines that its detection efficiency is very low in optical communication waveband. Although III-V group semiconductor materials are more suitable for photodetectors, III-V group semiconductor materials are incompatible with silicon technology and cannot be effectively integrated with silicon monolithically. Considering the compatibility between germanium material and CMOS process, the technology of forming germanium-silicon photodetector by using germanium material as the material of a light absorption layer is proposed in this field.

In a silicon photonic integrated chip, germanium-silicon material compatible with CMOS technology can be used to realize avalanche photoelectric detection, which uses silicon material as optical waveguide and avalanche gain region, and uses germanium material to absorb photons.

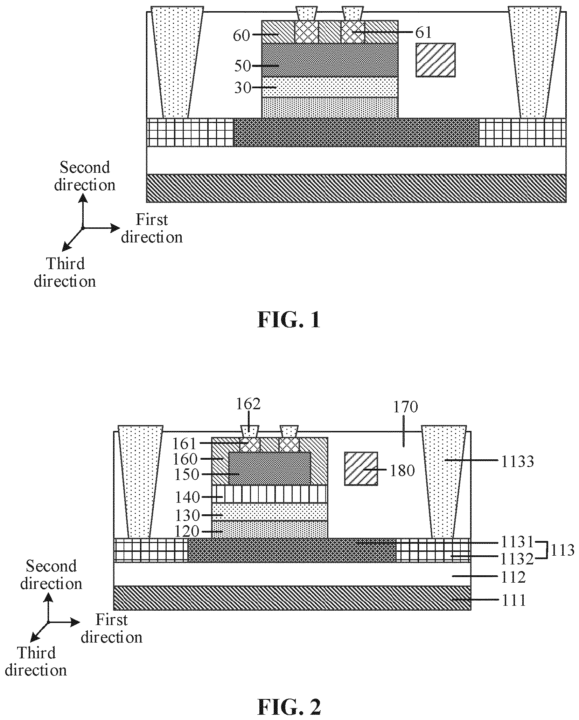

FIG. 1 is a side sectional view of an avalanche photodetector in the related art. In the related art, it is necessary to epitaxial grow an absorption layer 50 on a charge layer 30. The charge layer 30 is configured to regulate the electric field distribution inside the detector. The absorption layer 50 is configured to absorb target detection light and convert photons of the target detection light into photo-generated carrier pairs, thereby converting optical signals into electrical signals. Herein, the charge layer 30 is a doped silicon layer, and the absorption layer 50 is a germanium layer. However, since the charge layer 30 and the absorption layer 50 are different semiconductor material layers, and the charge layer 30 has doped ions, lattice mismatch will occur between the charge layer 30 and the absorption layer 50 during epitaxial growth, thereby leading to poor growth quality of the absorption layer 50, and thus reducing the responsivity of the detector. In addition, in the avalanche photodetector, it is required to arrange a heavy doped first electrode contact region on one side of the absorption layer 50, so as to form an electric field with a second electrode contact region for extracting photo-generated carriers. If the first electrode contact region is directly formed on the absorption layer 50 by doping, as the absorption layer 50 serves as a light absorption region, the doping will cause light absorption loss and reduce the quantum efficiency of the detector. Therefore, in general, the first electrode contact layer 60 is grown epitaxial on the absorption layer 50 first, and then a first electrode contact region 61 is formed by performing doping in the first electrode contact layer 60; the first electrode contact layer 60 is typically a silicon layer. However, due to the difference in material between the absorption layer 50 and the first electrode contact layer 60, lattice mismatch occurs during epitaxial growth, thereby leading to poor growth quality of the first electrode contact layer 60. In order to improve the growth quality, a transition layer can be arranged between each two semiconductor layers with different materials. However, if a transition layer is arranged between the charge layer 30 and the absorption layer 50, and between the absorption layer 50 and the first electrode contact layer 60, the process will be complicated and the cost will be high.

On the basis of this, the following technical solutions are proposed.

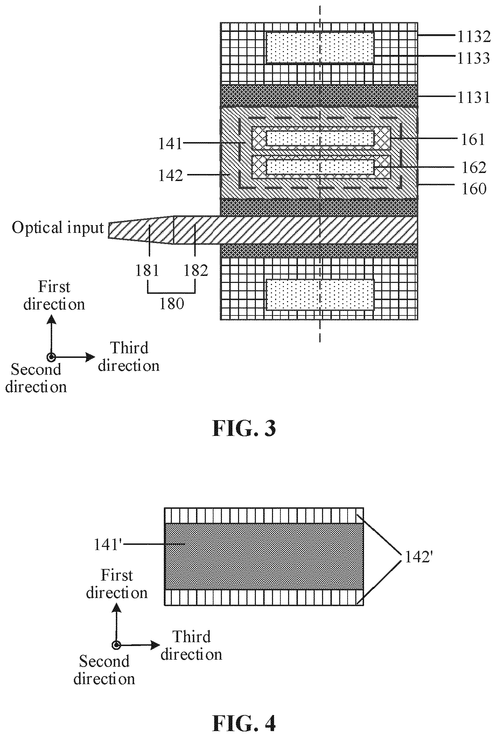

FIG. 2 is a side sectional view of an avalanche photodetector provided by an embodiment of the disclosure; and FIG. 3 is a top view of the avalanche photodetector provided by the embodiment of the disclosure. It should be noted that the side sectional view of FIG. 2 is obtained along the dashed line direction shown in FIG. 3. As shown in FIG. 2 and FIG. 3, the structure of the avalanche photodetector provided by the embodiments of the disclosure at least includes a substrate and a device structure layer on the substrate. The device structure layer at least includes a charge layer 130, a transition layer 140, an absorption layer 150 and a first electrode contact layer 160 which are sequentially arranged upward in a direction perpendicular to a plane of the substrate. Herein, the charge layer 130 is a layer of a first semiconductor material having a first doping type; the transition layer 140 is epitaxially grown on the charge layer 130, and the transition layer 140 is an intrinsic layer; the absorption layer 150 is epitaxially grown on a first region 141 of the transition layer 140, and the absorption layer 150 is an intrinsic layer of a second semiconductor material; the first electrode contact layer 160 is epitaxially grown on a second region 142 of the transition layer 140, and has a height higher than a height of the absorption layer 150 so that the first electrode contact layer 160 covers the absorption layer 150; the first electrode contact layer 160 is a layer of the first semiconductor material; and a material of the transition layer 140 is a composite material of the first semiconductor material and the second semiconductor material.

According to the invention, the transition layer 140 is added between the charge layer 130 and the absorption layer 150, the absorption layer 150 is located on the first region 141 of the transition layer 140, the first electrode contact layer 160 is located on the second region 142 of the transition layer 140 and on the absorption layer 150, and the transition layer 140 is the intrinsic layer, and the material of the transition layer is the composite material of the first semiconductor material and the second semiconductor material. In this way, the growth quality of the absorption layer 150 and the first electrode contact layer 160 is improved, which is not only conducive to reducing the dark current and improving the responsivity of the detector, but also makes the device structure simple and the process cost low

In an embodiment, the substrate may be an elemental semiconductor material substrate (e.g., silicon (Si) substrate, germanium (Ge) substrate, etc.), a composite semiconductor material substrate (e.g., germanium-silicon (SiGe) substrate, etc.), or a silicon on insulator (SOI) substrate, a germanium on insulator (GeOI) substrate, or the like. This embodiment is explained by taking the SOI substrate as a substrate, the SOI substrate includes a bottom substrate 111, a buried oxygen layer 112 and a top silicon layer 113. The bottom substrate 111 is a bottom silicon material, the buried oxygen layer 112 is located on the bottom substrate 111, the buried oxygen layer 112 is, for example, a silicon dioxide layer; and the top silicon layer 113 is located on the buried oxygen layer 112.

Herein, the substrate may include a top surface at a front face and a bottom surface at a back face opposite to the front face. A direction perpendicular to the top and bottom surfaces of the substrate is defined as a second direction in the case of ignoring the flatness of the top and bottom surfaces. The second direction is also the stacking direction of subsequent layers of the structure deposited on the substrate, or the height direction of the device. The plane where the top surface or the bottom surface of the substrate is located, or strictly speaking, the central plane in the thickness direction of the substrate, is determined as the plane of the substrate. The direction parallel to the plane of the substrate is the direction along the substrate plane. A first direction and a third direction intersecting each other are defined in the direction of the plane of the substrate. The first direction and the third direction are, for example, two directions perpendicular to each other. In the embodiment, as shown in FIG. 3, the dashed line direction in the figure is the first direction and the direction perpendicular to the dashed line direction is the third direction.

In an embodiment, a first doped region 1131 and a second doped region 1132 adjacent to each other are formed in the top silicon layer 113. The first doped region 1131 and the second doped region 1132 have the same doping type and both are in a second doping type different from the first doping type. The doping concentration of the second doped region 1132 is greater than the doping concentration of the first doped region 1131. The first doped region 1131 is, for example, an N+ doped region and the second doped region 1132 is, for example, an N++ doped region. The doping concentration of the first doped region 1131 is 2 × 10¹⁷/cm³ to 8 × 10¹⁸/cm³; and the doping concentration of the second doped region 1132 is 1 × 10²⁰/cm³ to 8 × 10²⁰/cm³.

The charge layer 130, the transition layer 140, the absorption layer 150 and the first electrode contact layer 160 are arranged directly above the first doped region 1131. The second doped region 1132 is used as a second electrode contact region of the avalanche photodetector.

It should be noted that there may be one or more second electrode contact regions 1132 on the top silicon layer 113. FIGS. 2 and 3 only illustrate the case that two second electrode contact regions 1132 are formed on the top silicon layer 113. Specifically, the two second electrode contact regions 1132 are respectively located on both sides of the first doped region 1131.

The avalanche photodetector further includes an avalanche layer 120 epitaxially grown on the top silicon layer 113, and the avalanche layer 120 is an intrinsic layer of the first semiconductor material.

The avalanche layer 120 has a size in a range of 700nm to 7000nm in the first direction, a size in a range of 100nm to 1500nm in the second direction; and a size in a range of 4 µm to 30 µm in the third direction.

Here, the avalanche layer of the avalanche photodetector refers to the region where the avalanche multiplication of carriers occurs. The absorption layer of the avalanche photodetector can convert the incident optical signal into a plurality of electron-hole pairs, which flow to the electrode under the action of electric field to form photocurrent. The photocurrent formed by the absorption layer is further amplified by the avalanche layer through the action of avalanche multiplication, and then a photoelectric detection is realized by conducting the photocurrent through a pair of metal electrodes.

In an embodiment, the charge layer 130 is located on the avalanche layer 120, and is a layer of the first semiconductor material with the first doping type.

The charge layer 130 is configured to regulate the distribution of an electric field inside the detector, so that there is a sufficiently high electric field in the avalanche layer 120 to enable the avalanche multiplication, and the absorption layer 150 has an appropriate electric field strength to prevent the electric field in the absorption layer 150 from being too high while ensuring high-speed drift of carriers, so as to prevent excessive tunnel dark current or harmful avalanche multiplication from being generated by the excessively high electric field.

The charge layer 130 has a size in a range of 700nm to 7000nm in the first direction, a size in a range of 50nm to 1000nm in the second direction, and a size in a range of 4 µm to 30 µm in the third direction.

According to the invention, the transition layer 140 is epitaxial grown on the charge layer 130, and the transition layer 140 is the intrinsic layer. The material of the transition layer 140 is the composite material of the first semiconductor material and the second semiconductor material.

The transition layer 140 may also be referred to as an interface layer.

The transition layer 140 has a size in a range of 700nm to 7000nm in the first direction, a size in a range of 20nm to 100nm in the second direction, and a size in a range of 4 µm to 30 µm in the third direction.

According to the invention, the absorption layer 150 is epitaxial grown on the first region 141 of the transition layer 140, and the absorption layer 150 is the intrinsic layer of the second semiconductor material.

The absorption layer 150 is configured to absorb target detection light and convert photons of the target detection light into photo-generated carrier pairs, thereby converting optical signals into electrical signals.

The lower surface of the absorption layer 150 is in direct contact with the first region 141 of the transition layer 140. One part of the lower surface of the first electrode contact layer 160 is in direct contact with the second region 142 of the transition layer 140, and the other part is in direct contact with the upper surface of the absorption layer 150. The first electrode contact layer 160 also covers the sidewall of the absorption layer 150 so as to be in direct contact with the sidewall.

The absorption layer 150 has a size in a range of 450nm to 5500nm in the first direction. The size of the absorption layer 150 in the first direction is less than the size of the transition layer 140 in the first direction, and the size difference therebetween is for example, in a range of 150nm to 1500nm.

The absorption layer 150 has a size in a range of 150nm to 600nm in the second direction.

The size of the absorption layer 150 in the third direction may be less than the size of the transition layer 140 in the third direction, and the size difference therebetween is, for example, greater than 150nm. The second region 142 surrounds the first region 14, and is a region of the transition layer 140 other than the first region 141. Specifically, as shown in FIG. 3, the first region 141 is, for example, a region within the smaller dashed line box, and the second region 142 is, for example, a region between the smaller dashed line box and the larger dashed line box in the figure.

In some other embodiments, the size of the absorption layer 150 in the third direction may be equal to the size of the transition layer 140 in the third direction. In this way, the absorption layer 150 may have a size in a range of 4µm to 30µm in the third direction. Specifically, as shown in FIG. 4, the second region 142' of the transition layer 140 is located on either side of the first region 141', so that the part, in contact with the transition layer 140, of the first electrode contact layer 160 is separated by the absorption layer 150 in the third direction. That is, the second region 142' includes two sub-regions separated by the first region 141'. The second region 142' may likewise be a region of the transition layer 140 other than the first region 141'.

According to the invention, the first electrode contact layer 160 is epitaxial grown on a second region 142 of the transition layer 140, and has a height higher than a height of the absorption layer 150, so that the first electrode contact layer 160 covers the absorption layer 150. The first electrode contact layer 160 is a layer of the first semiconductor material.

Here, the first semiconductor material is silicon, the second semiconductor material is germanium, the composite material of the first semiconductor material and the second semiconductor material is silicon-germanium (SiₓGe₁₋ₓ, where 0<x<1), and the first doping type is P type.

The doping concentration of the avalanche layer 120 is ≤ 2×10¹⁶/cm³. The doping concentration of the charge layer 130 is in a range from 2×10¹⁷/cm³ to 6×10¹⁸/cm³. The doping concentration of the transition layer 140 is ≤ 2×10¹⁵/cm³. The doping concentration of the absorption layer 150 is in a range from 2×10¹⁷/cm³ to 6×10¹⁸/cm³.

The top silicon layer 113 may also be referred to as a silicon flat layer. The avalanche layer 120 and the charge layer 130 may also be referred to as strip silicon waveguide layers. As such, the avalanche photodetector may include a region of silicon material, which may include the silicon flat layer and the strip silicon waveguide layers.

In an embodiment, the avalanche photodetector further includes a first electrode contact region 161 located in the first electrode contact layer 160. The first electrode contact region 161 is a region of the first semiconductor material with the first doping type. It should be understood that the first electrode contact layer 160 further includes an undoped intrinsic region. In a specific embodiment, the first electrode contact region 161 is a P+ doped region, such as a P+ doped silicon region. The doping concentration of the first electrode contact region 161 is in a range from 1×10¹⁹/cm³ to 2×10²⁰/cm³

It should be noted that there may be one or more first electrode contact regions 161 on the first electrode contact layer 160. FIGS. 2 and 3 only illustrate the case where two first electrode contact regions 161 are formed on the first electrode contact layer 160.

The first electrode contact region 161 is located on the absorption layer 150. In other words, the first electrode contact region 161 is located in the part covering the absorption layer 150, of the first electrode contact layer 160.

In an embodiment, the avalanche photodetector further includes an optical waveguide 180 arranged at a side of the absorption layer 150 in the direction parallel to the plane of the substrate. The optical waveguide 180 is configured to transmit the optical signal and couple the optical signal to the absorption layer 150.

Specifically, the material of the optical waveguide 180 may be silicon nitride. That is, the optical waveguide 180 may be a silicon nitride optical waveguide. In other embodiments, the material of the optical waveguide 180 may also be silicon.

In an embodiment, the upper surface of the optical waveguide 180 may be flush with or higher than the upper surface of the absorption layer 150. The lower surface of the optical waveguide 180 may be flush with or lower than the lower surface of the absorption layer 150.

The distance between the optical waveguide 180 and the absorption layer 150 is in a range from 100nm to 500nm.

The optical waveguide 180 includes an optical input port 181 and a first waveguide region 182. The first waveguide region 182 is a straight waveguide region.

The optical signal transmitted by the optical waveguide 180 is transmitted along the direction from the optical input port 181 to the first waveguide region 182.

The optical waveguide 180 has a size in a range of 500nm to 3000nm in the first direction, a size in a range of 100nm to 900nm in the second direction, and a size in a range of 5 µm to 32 µm in the third direction.

A filling layer 170 is arranged between the optical waveguide 180 and the absorption layer 150, and also arranged between the optical waveguide 180 and the top silicon layer 113. As shown in FIG. 2, the filling layer 170 covers the top silicon layer 113 and the absorption layer 150. The optical waveguide 180 is arranged within the filling layer 170 and separated from each of the top silicon layer 113 and the absorption layer 150 by a certain distance. The filling layer 170 is configured to support and fix the optical waveguide 180, and has a lower refractive index, so that the transmitted optical signal can be optically constrained.

The difference in the refractive index between the optical waveguide 180 and the absorption layer 150 is large, and the optical waveguide 180 is provided on the side surface of the absorption layer 150, thereby improving the coupling efficiency of the optical signal from the optical waveguide 180 to the absorption layer 150. It can be understood that the higher the coupling efficiency, the more photons are coupled into the absorption layer 150. By this way, the coupling region with a shorter length can achieve a high response speed. It should be noted that the length of the coupling region is equal to the length of the absorption layer 150 in the third direction. In this way, the gain-bandwidth product of the detector can increase by reducing the size of the region of the absorption layer 150.

The sidewall of the absorption layer 150 has a projection having a second shape on the silicon flat layer 113. In the embodiment shown in FIG. 3, the second shape may be a rectangle having a long side extending in the third direction and a short side extending in the first direction. Herein, the length of the second shape in the third direction is the length of the long side of the rectangle, and the length of the first shape in the first direction is the length of the short side of the rectangle. Combined with FIG.3, it should be understood that, the length of the coupling region is the length of the second shape in the third direction. For example, the absorption layer 150 has a length of 4µm to 30µm in the third direction. That is, the length of the coupling region is 4µm to 30µm. The length of the coupling region can be controlled by controlling the length of the absorption layer 150 in the third direction.

In an embodiment, the optical waveguide 180 is designed as a lateral waveguide, which enables light to slowly couple into the absorption layer 150 and strongly interact with the absorption layer 150. At the same time, due to the decoupling of the absorption layer 150 and the avalanche layer 120 and the design of adding the intrinsic transition layer 140, the avalanche photoelectric detection with low dark current, high gain, large bandwidth and high quantum efficiency can be realized.

In an embodiment, a first electrode contact region 161 is formed on the first electrode contact layer 160, and a second electrode contact region 1132 is formed on the top silicon layer 113. A first metal electrode 162 and a second metal electrode 1133 are respectively provided on the first electrode contact region 161 and the second electrode contact region 1132.

Any one of the first metal electrode 162 and the second metal electrode 1133 is 700nm or more away from the optical waveguide 180.

In an embodiment, an applied voltage is applied between the second metal electrode 1133 on the top silicon layer 113 and the first metal electrode 162 on the first electrode contact layer 160 to form an applied electric field, to extract carriers generated in the absorption layer 150. The electric field direction of the applied electric field is the same as that of the built-in electric field formed in the absorption layer 150, so that the moving speed of the carriers can be accelerated through this applied electric field, thereby improving the responsivity of the avalanche detector.

In an embodiment, the avalanche photodetector is based on the designed structure with vertical electrode, so that the electric field distribution in the absorption layer is uniform, while decoupling light transmission, light absorption, and light multiplication, thereby facilitating the transport of photo-generated carriers and being beneficial to improving the gain-bandwidth product.

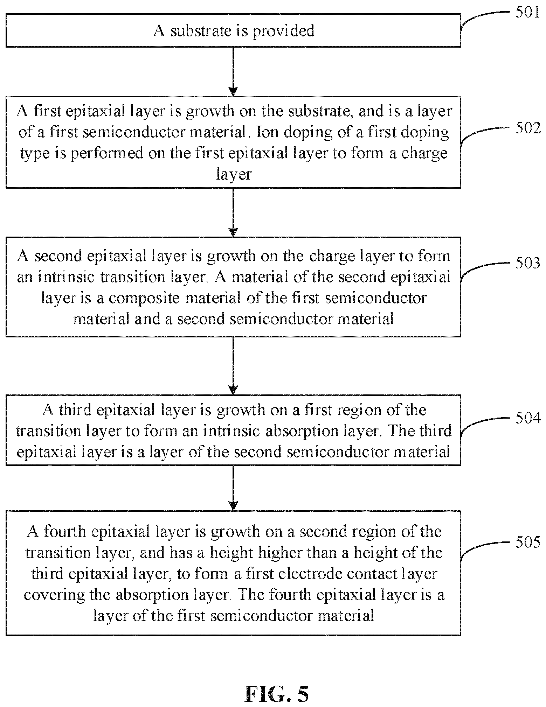

A method according to the invention for preparing an avalanche photodetector is provided with specific reference to FIG. 5. As shown in FIG.5, the method includes the following operations.

In S501, a substrate is provided.

In S502, a first epitaxial layer is grown on the substrate, in which the first epitaxial layer is a layer of a first semiconductor material. Ion doping of a first doping type is performed on the first epitaxial layer to form a charge layer.

In S503, a second epitaxial layer is grown on the charge layer to form an intrinsic transition layer. A material of the second epitaxial layer is a composite material of the first semiconductor material and a second semiconductor material.

In S504, a third epitaxial layer is grown on a first region of the transition layer to form an intrinsic absorption layer. The third epitaxial layer is a layer of the second semiconductor material.

In S505, a fourth epitaxial layer is grown on a second region of the transition layer, and has a height higher than a height of the third epitaxial layer to form a first electrode contact layer covering the absorption layer. The fourth epitaxial layer is a layer of the first semiconductor material.

The method for preparing the avalanche photodetector of the disclosure will be further described in detail below with reference to the specific embodiments.

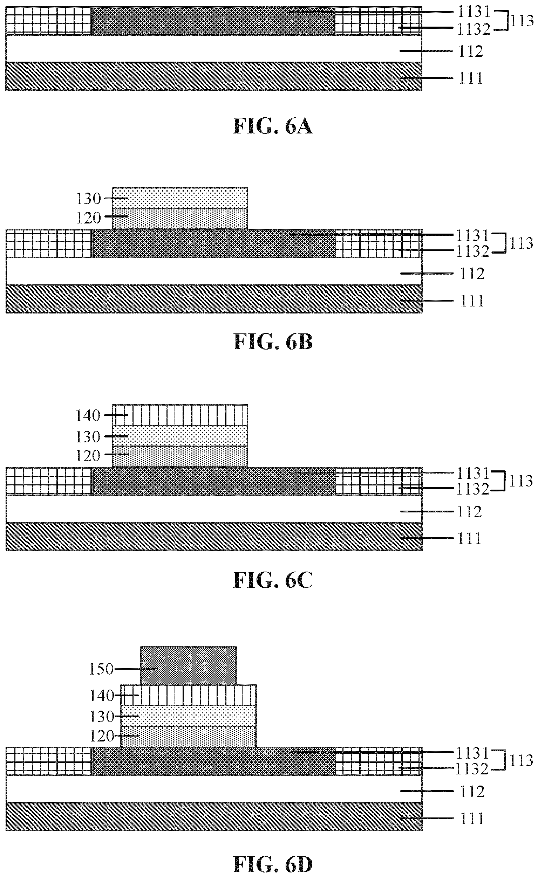

FIG. 6A to FIG. 6H are side sectional views of structures of an avalanche photodetector provided by an embodiment of the disclosure during the process of preparing.

First, with reference to FIG. 6A, S501 is performed, in which a substrate is provided. The substrate may be an elemental semiconductor material substrate (e.g. silicon (Si) substrate, germanium (Ge) substrate, etc.), a composite semiconductor material substrate (e.g. germanium-silicon (SiGe) substrate, etc.), or a silicon on insulator (SOI) substrate, a germanium on insulator (GeOI) substrate, or the like.

This embodiment is explained by taking an SOI substrate as the substrate. The SOI substrate includes a bottom substrate 111, a buried oxygen layer 112, and a top silicon layer 113. The bottom substrate 111 is a bottom silicon material, the buried oxygen layer 112 is located on the bottom substrate 111, the buried oxygen layer 112 is, for example, a silicon dioxide layer, and the top silicon layer 113 is located on the buried oxygen layer 112.

In an embodiment, by means of lithographic or ion implantation doping processes or the like, a first doped region 1131 and a second doped region 1132 disposed adjacent to each other are formed on the top silicon layer 113. The first doped region 1131 and the second doped region 1132 have the same doping type and both are a second doping type. The doping concentration of the second doped region 1132 is greater than the doping concentration of the first doped region 1131. The first doped region 1131 is, for example, an N+ doped region and the second doped region 1132 is, for example, an N++ doped region. The doping concentration of the first doped region 1131 is in a range of 2×10¹⁷/cm³ to 8×10¹⁸/cm³, and the doping concentration of the second doped region 1132 is in a range of 1×10²⁰/cm³ to 8×10²⁰/cm³.

It should be noted that there may be one or more second doped regions 1132 on the top silicon layer 113, and FIG. 6A only illustrates the case where two second doped regions 1132 are formed on the top silicon layer 113, in which the two second electrode contact regions 1132 are respectively located on both sides of the first doped region 1131.

Subsequently, with reference to FIG. 6B, S502 is performed, in which a selective epitaxial grown process is performed, so as to grow the first epitaxial layer on the top silicon layer 113 to form the avalanche layer 120. The first epitaxial layer is a layer of the first semiconductor material. Next, a selective doping process is performed to perform the ion doping of a first doping type on the first epitaxial layer to form the charge layer 130.

The avalanche layer 120 has a size in a range of 700nm to 7,000nm in the first direction, a size in a range of 100nm to 1,500nm in the second direction; and a size in a range of 4 µm to 30 µm in the third direction.

The charge layer 130 has a size in a range of 700nm to 7,000nm in the first direction, a size in a range of 50nm to 1,000nm in the second direction; and a size in a range of 4 µm to 30 µm in the third direction.

Subsequently, with reference to FIG. 6C, S503 is performed, in which a selective epitaxial grown process is performed, so as to grow the second epitaxial layer on the charge layer 130 to form the intrinsic transition layer 140. the material of the second epitaxial layer is the composite material of the first semiconductor material and the second semiconductor material.

The transition layer 140 has a size in a range of 700nm to 7,000nm in the first direction, a size in a range of 20nm to 100nm in the second direction; and a size in a range of 4 µm to 30 µm in the third direction.

Next, with reference to FIG. 6D, S504 is performed, in which a selective epitaxial grown process is performed again, so as to grow a third epitaxial layer on a first region 141 of the transition layer 140 to form the intrinsic absorption layer 150. The material of the third epitaxial layer is the second semiconductor material.

The absorption layer 150 has a size in a range of 450nm to 5,500nm in the first direction. The size of the absorption layer 150 in the first direction is smaller than the size of the transition layer 140 in the first direction, and the size difference therebetween is for example, in a range of 150nm to 1,500nm.

The absorption layer 150 has a size in a range of 150nm to 600nm in the second direction.

The size of the absorption layer 150 in the third direction may be smaller than the size of the transition layer 140 in the third direction, and the size difference therebetween is for example greater than 150nm. The second region 142 surrounds the first region 141. The second region 142 is a region on the transition layer 140 other than the first region 141. Specifically, as shown in FIG. 3, the first region 141 is, for example, a region within the smaller dashed line box in the figure and the second region 142 is for example a region between the smaller dashed line box and the larger dashed line box in the figure.

In some other embodiments, the size of the absorption layer 150 in the third direction may be equal to the size of the transition layer 140 in the third direction. In this way, the absorption layer 150 may have a size in a range of 4µm to 30µm in the third direction. Specifically, as shown in FIG. 4, the second region 142' of the transition layer 140 is located on either side of the first region 141', so that the part, in contact with the transition layer 140, of the first electrode contact layer 160 is separated by the absorption layer 150 in the third direction. That is, the second region 142' includes two sub-regions separated by the first region 141'. The second region 142' may likewise be a region on the transition layer 140 other than the first region 141'.

The doping concentration of the avalanche layer 120 is ≤ 2×10¹⁶/cm³. The doping concentration of the charge layer 130 is in a range from 2×10¹⁷/cm³ to 6×10¹⁸/cm³. The doping concentration of the transition layer 140 is ≤ 2×10¹⁵/cm³. The doping concentration of the absorption layer 150 is in a range from 2×10¹⁷/cm³ to 6×10¹⁸/cm³.

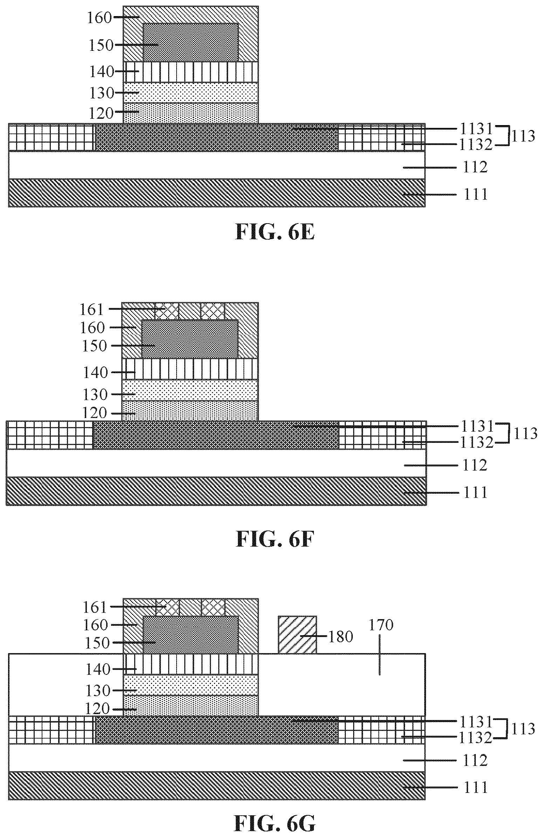

Subsequently, with reference to FIG. 6E, S505 is performed, in which a selective epitaxial grown process is performed, so as to grow the fourth epitaxial layer on a second region 142 of the transition layer 140. The height of the fourth epitaxial layer is higher than a height of the third epitaxial layer to form the first electrode contact layer 160 covering the absorption layer 150. The fourth epitaxial layer is a layer of the first semiconductor material.

The lower surface of the absorption layer 150 is in direct contact with the first region 141 of the transition layer 140. One part of the lower surface of the first electrode contact layer 160 is in direct contact with the second region 142 of the transition layer 140, and the other part is in direct contact with the upper surface of the absorption layer 150. The first electrode contact layer 160 also covers the sidewall of the absorption layer 150 so as to be in direct contact with the sidewall.

Here, the first semiconductor material is silicon, the second semiconductor material is germanium, the composite material of the first semiconductor material and the second semiconductor material is silicon-germanium; and the first doping type is P type.

With reference to FIG. 6F, after S405 is completed, the method further includes an operation of performing ion doping of a first doping type on the fourth epitaxial layer by using lithography and ion implantation doping processes or the like to form the first electrode contact region 161 on the first electrode contact layer 160. That is, the first electrode contact region 161 is a P+ doped silicon region, and the doping concentration of the first electrode contact region 161 is in a range from 1×10¹⁹/cm³ to 2×10²⁰/cm³.

It should be noted that there may be one or more first electrode contact regions 161 on the first electrode contact layer 160. In this embodiment, there are two first electrode contact regions 161.

The first electrode contact region 161 is located on the absorption layer 150. In other words, the first electrode contact region 161 is located in the part, covering the absorption layer 150, of the first electrode contact layer 160.

It should be understood that after each of the above-described selective epitaxial growth processes is performed, a planarization step may be performed, which is not described in detail herein.

In an embodiment, the top silicon layer 113 may also be referred to as a silicon flat layer. The avalanche layer 120 and the charge layer 130 may also be referred to as strip silicon waveguide layers. As such, the avalanche photodetector may include a silicon material region, and the silicon material region may include the silicon flat layer and the strip silicon waveguide layers.

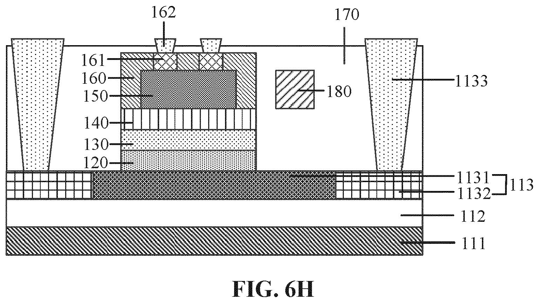

Next, reference is made to FIGS. 6G and 6H. First, with reference to FIG. 6G, the method further includes an operation of forming an optical waveguide 180 located on a side of the absorption layer 150 in a direction parallel to the plane of the substrate.

In an embodiment, a filling layer 170 is formed on the substrate, specifically on the top silicon layer 113, before forming the optical waveguide 180.

The material of the filling layer 170 may include silicon dioxide.

In an actual process, the filling layer 170 may be formed by depositing a certain thickness of silicon dioxide material and performing a planarization process.

Next, a region where the optical waveguide needs to be formed may be defined on the filling layer 170 by a patterned mask layer (not shown in the figure). The optical waveguide material is grown in the region, specifically for example, silicon nitride material is deposited or silicon material is grown, to form the optical waveguide 180.

In an embodiment, the upper surface of the optical waveguide 180 may be flush with or higher than the upper surface of the absorption layer 150. The lower surface of the optical waveguide 180 may be flush with or lower than the lower surface of the absorption layer 150.

The material of the optical waveguide 180 may be specifically silicon nitride, i.e. the optical waveguide 180 may be a silicon nitride optical waveguide. In other embodiments, the material of the optical waveguide 180 may also be silicon.

The optical waveguide 180 is configured to transmit an optical signal and couple the optical signal to the absorption layer 150.

The distance between the optical waveguide 180 and the absorption layer 150 is in a range from 100nm to 500nm.

The optical waveguide 180 includes an optical input port 181 and a first waveguide region 182. The first waveguide region 182 is a straight waveguide region.

The optical signal transmitted by the optical waveguide 180 is propagated along the direction from the optical input port 181 to the first waveguide region 182.

The optical waveguide 180 has a size in a range of 500nm to 3,000nm in the first direction, a size in a range of 100nm to 900nm in the second direction, and a size in a range of 5 µm to 32 µm in the third direction.

Next, with reference to FIG. 6H, the method further includes an operation of forming a first metal electrode 162 and a second metal electrode 1133 disposed perpendicular to the direction of the substrate plane (i.e., the second direction) on the first electrode contact region 161 of the first electrode contact layer 160 and the second electrode contact region 1132 of the top silicon layer 113, respectively.

Specifically, the two metal electrodes can be prepared by opening window through photolithography and inductive plasma etching, depositing a metal material by magnetron sputtering and other processes.

Any one of the first metal electrode 162 and the second metal electrode 1133 is 700nm or more away from the optical waveguide 180.

The upper surfaces of the first metal electrode 162 and the second metal electrode 1133 should be higher than the upper surface of the optical waveguide 180. Specifically, the method further includes the following operations. A filling layer 170 is formed on the optical waveguide 180. Windows exposing the first electrode contact region 161 and the second electrode contact region 1132 are formed in the filling layer 170 by processes, such as photolithography and etching (such as inductive plasma etching). An electrode material is filled in the windows (e.g. depositing a metal material by magnetron sputtering) to form the first metal electrode 162 and the second metal electrode 1133.

As such, the preparation of the avalanche photodetector is basically completed. Some interconnection processes may be involved in the follow-up processes, which will not be discussed here.

It should be noted that the avalanche photodetector provided in the embodiments of the disclosure and the method for preparing an avalanche photodetector provided in the embodiments of the disclosure belong to the same concept. Any technical feature(s) of the technical solution described in each embodiment can be arbitrarily combined with each other if there is no conflict, which is not repeated herein.

The described embodiments are not intended to limit the protection scope of the claims. The scope of protection is defined by the claims.

## Claims

1. An avalanche photodetector, comprising a substrate and a device structure layer on the substrate; wherein the device structure layer at least comprises a charge layer (130), a transition layer (140), an absorption layer (150) and a first electrode contact layer (160) which are arranged in sequence upward in a direction perpendicular to a plane of the substrate; wherein,
the charge layer (130) is a layer of a first semiconductor material having a first doping type;
the transition layer (140) is epitaxially grown on the charge layer (130), and is an intrinsic layer;
the absorption layer (150) is epitaxially grown on a first region (141) of the transition layer (140), and is an intrinsic layer of a second semiconductor material;
the first electrode contact layer (160) is epitaxially grown on a second region (142) of the transition layer (140), and has a height higher than a height of the absorption layer (150) so that the first electrode contact layer (160) covers the absorption layer (150); and the first electrode contact layer (160) is a layer of the first semiconductor material; and
a material of the transition layer (140) is a composite material of the first semiconductor material and the second semiconductor material.

2. The avalanche photodetector according to claim 1, wherein,
the first semiconductor material is silicon;
the second semiconductor material is germanium; and
the composite material of the first semiconductor material and the second semiconductor material is silicon-germanium.

3. The avalanche photodetector according to claim 1, wherein the first doping type is P type.

4. The avalanche photodetector according to claim 1, wherein the avalanche photodetector further comprises a first electrode contact region (161) in the first electrode contact layer (160), and the first electrode contact region (161) is a region of the first semiconductor material with the first doping type.

5. The avalanche photodetector according to claim 1, wherein,
the second region (142) surrounds the first region (141); or,
the second region (142) comprises two sub-regions separated by the first region (141).

6. A method for preparing an avalanche photodetector, comprising
providing a substrate;
growing a first epitaxial layer on the substrate, the first epitaxial layer being a layer of a first semiconductor material; performing ion doping of a first doping type on the first epitaxial layer to form a charge layer (130);
growing a second epitaxial layer on the charge layer (130) to form an intrinsic transition layer (140); a material of the second epitaxial layer being a composite material of the first semiconductor material and a second semiconductor material;
growing a third epitaxial layer on a first region (141) of the transition layer (140) to form an intrinsic absorption layer (150); the third epitaxial layer being a layer of the second semiconductor material; and
growing a fourth epitaxial layer on a second region (142) of the transition layer (140), the fourth epitaxial layer having a height higher than a height of the third epitaxial layer to form a first electrode contact layer (160) covering the absorption layer (150); the fourth epitaxial layer being a layer of the first semiconductor material.

7. The method for preparing an avalanche photodetector according to claim 6, wherein,
the first semiconductor material is silicon;
the second semiconductor material is germanium; and
the composite material of the first semiconductor material and the second semiconductor material is silicon-germanium.

8. The method for preparing an avalanche photodetector according to claim 6, wherein the first doping type is P type.

9. The method for preparing an avalanche photodetector according to claim 6, further comprising:
performing ion doping of a first doping type on the fourth epitaxial layer to form a first electrode contact region (161) in the first electrode contact layer (160).

10. The method for preparing an avalanche photodetector according to claim 6, wherein,
the second region (142) surrounds the first region (141); or,
the second region (142) comprises two sub-regions separated by the first region (141).

## Patentansprüche

1. Lawinenphotodetektor, der ein Substrat und eine Vorrichtungsstrukturschicht auf dem Substrat umfasst; wobei die Vorrichtungsstrukturschicht zumindest eine Ladungsschicht (130), eine Übergangsschicht (140), eine Absorptionsschicht (150) und eine erste Elektrodenkontaktschicht (160) umfasst, die der Reihe nach aufwärts in einer Richtung senkrecht zu einer Ebene des Substrats angeordnet sind; wobei
die Ladungsschicht (130) eine Schicht aus einem ersten Halbleitermaterial ist, das einen ersten Dotierungstyp aufweist;
die Übergangsschicht (140) epitaktisch auf der Ladungsschicht (130) gewachsen ist und eine intrinsische Schicht ist;
die Absorptionsschicht (150) epitaktisch auf einem ersten Bereich (141) der Übergangsschicht (140) gewachsen ist und eine intrinsische Schicht aus einem zweiten Halbleitermaterial ist;
die erste Elektrodenkontaktschicht (160) epitaktisch auf einem zweiten Bereich (142) der Übergangsschicht (140) gewachsen ist und eine Höhe aufweist, die höher ist als eine Höhe der Absorptionsschicht (150), sodass die erste Elektrodenkontaktschicht (160) die Absorptionsschicht (150) bedeckt; und die erste Elektrodenkontaktschicht (160) eine Schicht aus dem ersten Halbleitermaterial ist; und
ein Material der Übergangsschicht (140) ein Verbundmaterial aus dem ersten Halbleitermaterial und dem zweiten Halbleitermaterial ist.

2. Lawinenphotodetektor nach Anspruch 1, wobei
das erste Halbleitermaterial Silizium ist;
das zweite Halbleitermaterial Germanium ist; und
das Verbundmaterial aus dem ersten Halbleitermaterial und dem zweiten Halbleitermaterial Silizium-Germanium ist.

3. Lawinenphotodetektor nach Anspruch 1, wobei der erste Dotierungstyp vom P-Typ ist.

4. Lawinenphotodetektor nach Anspruch 1, wobei der Lawinenphotodetektor weiter einen ersten Elektrodenkontaktbereich (161) in der ersten Elektrodenkontaktschicht (160) umfasst und der erste Elektrodenkontaktbereich (161) ein Bereich aus dem ersten Halbleitermaterial mit dem ersten Dotierungstyp ist.

5. Lawinenphotodetektor nach Anspruch 1, wobei
der zweite Bereich (142) den ersten Bereich (141) umgibt; oder
der zweite Bereich (142) zwei vom ersten Bereich (141) getrennte Unterbereiche umfasst.

6. Verfahren zum Herstellen eines Lawinenphotodetektors, umfassend
Bereitstellen eines Substrats;
Wachsen einer ersten epitaktischen Schicht auf dem Substrat, wobei die erste epitaktische Schicht eine Schicht aus einem ersten Halbleitermaterial ist; Durchführen einer lonendotierung eines ersten Dotierungstyps auf der ersten epitaktischen Schicht, um eine Ladungsschicht (130) zu bilden;
Wachsen einer zweiten epitaktischen Schicht auf der Ladungsschicht (130), um eine intrinsische Übergangsschicht (140) zu bilden; wobei ein Material der zweiten epitaktischen Schicht ein Verbundmaterial aus dem ersten Halbleitermaterial und einem zweiten Halbleitermaterial ist;
Wachsen einer dritten epitaktischen Schicht auf einem ersten Bereich (141) der Übergangsschicht (140), um eine intrinsische Absorptionsschicht (150) zu bilden; wobei die dritte epitaktische Schicht eine Schicht aus dem zweiten Halbleitermaterial ist; und
Wachsen einer vierten epitaktischen Schicht auf einem zweiten Bereich (142) der Übergangsschicht (140), wobei die vierte epitaktische Schicht eine Höhe aufweist, die höher als eine Höhe der dritten epitaktischen Schicht ist, um eine erste Elektrodenkontaktschicht (160) zu bilden, welche die Absorptionsschicht (150) bedeckt; wobei die vierte epitaktische Schicht eine Schicht aus dem ersten Halbleitermaterial ist.

7. Verfahren zum Herstellen eines Lawinenphotodetektors nach Anspruch 6, wobei
das erste Halbleitermaterial Silizium ist;
das zweite Halbleitermaterial Germanium ist; und
das Verbundmaterial aus dem ersten Halbleitermaterial und dem zweiten Halbleitermaterial Silizium-Germanium ist.

8. Verfahren zum Herstellen eines Lawinenphotodetektors nach Anspruch 6, wobei der erste Dotierungstyp vom P-Typ ist.

9. Verfahren zum Herstellen eines Lawinenphotodetektors nach Anspruch 6, weiter umfassend:
Durchführen einer lonendotierung eines ersten Dotierungstyps auf der vierten epitaktischen Schicht, um einen ersten Elektrodenkontaktbereich (161) in der ersten Elektrodenkontaktschicht (160) zu bilden.

10. Verfahren zum Herstellen eines Lawinenphotodetektors nach Anspruch 6, wobei
der zweite Bereich (142) den ersten Bereich (141) umgibt; oder
der zweite Bereich (142) zwei vom ersten Bereich (141) getrennte Unterbereiche umfasst.

## Revendications

1. Photodétecteur à avalanche, comprenant un substrat et une couche de structure de dispositif sur le substrat ; dans lequel la couche de structure de dispositif comprend au moins une couche de charge (130), une couche de transition (140), une couche d'absorption (150) et une première couche de contact d'électrode (160) qui sont agencées en séquence vers le haut dans une direction perpendiculaire à un plan du substrat ; dans lequel,
la couche de charge (130) est une couche d'un premier matériau semi-conducteur présentant un premier type de dopage ;
la couche de transition (140) est développée épitaxialement sur la couche de charge (130) et est une couche intrinsèque ;
la couche d'absorption (150) est développée épitaxialement sur une première région (141) de la couche de transition (140), et est une couche intrinsèque d'un second matériau semi-conducteur ;
la première couche de contact d'électrode (160) est développée épitaxialement sur une seconde région (142) de la couche de transition (140), et présente une hauteur supérieure à une hauteur de la couche d'absorption (150) de sorte que la première couche de contact d'électrode (160) couvre la couche d'absorption (150) ; et la première couche de contact d'électrode (160) est une couche du premier matériau semi-conducteur ; et
un matériau de la couche de transition (140) est un matériau composite du premier matériau semi-conducteur et du second matériau semi-conducteur.

2. Photodétecteur à avalanche selon la revendication 1, dans lequel,
le premier matériau semi-conducteur est du silicium ;
le second matériau semi-conducteur est du germanium ; et
le matériau composite du premier matériau semi-conducteur et du second matériau semi-conducteur est du silicium-germanium.

3. Photodétecteur à avalanche selon la revendication 1, dans lequel le premier type de dopage est de type P.

4. Photodétecteur à avalanche selon la revendication 1, dans lequel le photodétecteur à avalanche comprend en outre une première région de contact d'électrode (161) dans la première couche de contact d'électrode (160), et la première région de contact d'électrode (161) est une région du premier matériau semi-conducteur avec le premier type de dopage.

5. Photodétecteur à avalanche selon la revendication 1, dans lequel,
la seconde région (142) entoure la première région (141) ; ou,
la seconde région (142) comprend deux sous-régions séparées par la première région (141).

6. Procédé de préparation d'un photodétecteur à avalanche, comprenant les étapes consistant à
fournir un substrat ;
développer une première couche épitaxiale sur le substrat, la première couche épitaxiale étant une couche d'un premier matériau semi-conducteur ; effectuer un dopage ionique d'un premier type de dopage sur la première couche épitaxiale pour former une couche de charge (130) ;
développer une deuxième couche épitaxiale sur la couche de charge (130) pour former une couche de transition intrinsèque (140) ; un matériau de la deuxième couche épitaxiale étant un matériau composite du premier matériau semi-conducteur et d'un second matériau semi-conducteur ;
développer une troisième couche épitaxiale sur une première région (141) de la couche de transition (140) pour former une couche d'absorption intrinsèque (150) ; la troisième couche épitaxiale étant une couche du second matériau semi-conducteur ; et
développer une quatrième couche épitaxiale sur une seconde région (142) de la couche de transition (140), la quatrième couche épitaxiale présentant une hauteur supérieure à une hauteur de la troisième couche épitaxiale pour former une première couche de contact d'électrode (160) couvrant la couche d'absorption (150) ; la quatrième couche épitaxiale étant une couche du premier matériau semi-conducteur.

7. Procédé de préparation d'un photodétecteur à avalanche selon la revendication 6, dans lequel,
le premier matériau semi-conducteur est du silicium ;
le second matériau semi-conducteur est du germanium ; et
le matériau composite du premier matériau semi-conducteur et du second matériau semi-conducteur est du silicium-germanium.

8. Procédé de préparation d'un photodétecteur à avalanche selon la revendication 6, dans lequel le premier type de dopage est de type P.

9. Procédé de préparation d'un photodétecteur à avalanche selon la revendication 6, comprenant en outre les étapes consistant à :
effectuer un dopage ionique d'un premier type de dopage sur la quatrième couche épitaxiale pour former une première région de contact d'électrode (161) dans la première couche de contact d'électrode (160).

10. Procédé de préparation d'un photodétecteur à avalanche selon la revendication 6, dans lequel,
la seconde région (142) entoure la première région (141) ; ou,
la seconde région (142) comprend deux sous-régions séparées par la première région (141).
